## Europäisches Patentamt

## European Patent Office

## Office européen des brevets

(11) Veröffentlichungsnummer: **0 034 211**
**B1**

(12) **EUROPÄISCHE PATENTSCHRIFT**

(45) Veröffentlichungstag der Patentschrift:
**03.07.85**

(21) Anmeldenummer: **80107579.7**

(22) Anmeldetag: **04.12.80**

(51) Int. Cl.⁴: **H 01 L 31/02, H 01 L 25/04**

(54) **Solarzellenanordnung.**

(30) Priorität: **16.02.80 DE 3005914**

(43) Veröffentlichungstag der Anmeldung:
**26.08.81 Patentblatt 81/34**

(45) Bekanntmachung des Hinweises auf die Patenterteilung:
**03.07.85 Patentblatt 85/27**

(84) Benannte Vertragsstaaten:
**BE CH DE FR GB LI NL**

(56) Entgegenhaltungen:
**DE - A - 2 833 261**
**US - A - 3 578 845**
**US - A - 3 763 372**
**US - A - 3 971 672**
**US - A - 4 021 267**
**US - A - 4 204 881**

**RCA REVIEW, Band 33, Nr. 1, März 1972, Seiten 110-130 Princeton, U.S.A. D. MEYERHOFER: "Phase holograms in dichromated gelatin"**

(73) Patentinhaber: **Bloss, Werner H.,Prof. Dr.-Ing,
Lindenstrasse 45, D-7065 Winterbach (DE)**

(72) Erfinder: **Bloss, Werner H., Prof.Dr.Ing.,
Lindenstrasse 45, D-7065 Winterbach (DE)**
Erfinder: **Hewig, Gert H., Dr.Ing., Goldäckerstrasse 62,
D-7031 Steinenbronn (DE)**
Erfinder: **Laub, Gerhard, Dipl.-Phys., Aspergstrasse 34,
D-7000 Stuttgart 1 (DE)**
Erfinder: **Reinhardt, Erich, Dr.Ing., Burgherrenstrasse 91,
D-7000 Stuttgart 30 (DE)**

(74) Vertreter: **Wilhelm, Hans-Herbert, Dr.-Ing. et al,
Gymnasiumstrasse 31B, D-7000 Stuttgart 1 (DE)**

## Beschreibung

Die Erfindung betrifft eine Solarzellenanordnung mit mindestens zwei Solarzellen unterschiedlicher Absorptionsfähigkeit und einem optischen System, das sowohl fokussierend als auch dispersiv wirkt und das das einfallende Licht auf die Oberflächen der Solarzellen in der Weise abbildet, dass jeder Solarzelle das ihrer jeweiligen Absorptionsfähigkeit entsprechende spektrale Licht zugeleitet wird.

Es ist bekannt, dass die Absorptionsfähigkeit von Solarzellen je nach ihrer Beschaffenheit für bestimmte Spektralbereiche des einfallenden Lichtes wesentlich grösser ist als für andere Spektralbereiche. Um die gesamte Bandbreite des einfallenden Sonnenlichtes auszunutzen, ist es daher vorteilhaft und zweckmässig, verschiedene Solarzellen oder Solarzellengruppen vorzusehen, die auf Grund ihrer verschiedenartigen Beschaffenheit jeweils das Maximum ihrer Absorptionsfähigkeit in verschiedenen Spektralbereichen des Lichtes aufweisen. So ist es beispielsweise theoretisch bekannt, eine Anordnung von mehreren aufeinandergeschichteten Solarzellen oder Solarzellengruppen vorzusehen, von denen jede Schicht bestimmte Spektralbereiche des Lichtes entsprechend dem Bandabstand des verwendeten Materials absorbiert. Nachteilig ist bei solchen Anordnungen, dass die Übergänge zwischen den Schichten entweder über Kontaktschichten oder über Kontaktgitter vorgenommen werden müssen, die selbst wieder absorbieren und damit zu Verlusten der Gesamtanordnung führen. Werden die Solarzellenschichten in Serie geschaltet, dann ist die Stromdichte limitiert durch die Schicht, welche den geringsten Strom erzeugt. Da sich ausserdem auch das Spektrum des einfallenden Lichtes ändern kann, so können sich auch die Stromdichten der einzelnen Schichten ändern, so dass insgesamt eine weitere Verschlechterung der Stromausbeute eintritt.

Es sind auch schon Anordnungen mit dichroitischen Spiegeln und mit einzeln angeordneten Solarzellen vorgeschlagen worden, wobei die einzelnen Spektralbereiche des Lichtes zum Teil reflektiert bzw. durchgelassen werden, so dass den Solarzellen bestimmte Spektralbereiche zugeordnet werden können. Nachteilig ist bei diesen Anordnungen, dass das optische System sehr aufwendig aufgebaut ist und dass auch die zu verwendende Mechanik aufwendig ist, weil das Fokussiersystem zur Erzielung des grösstmöglichen Wirkungsgrades dem Sonnenlicht nachgeführt werden muss.

Bekannt sind auch Solarzellenanordnungen der eingangs genannten Art (US-A-4021267), bei denen ein Prisma verwendet wird, um das einfallende Licht in seine spektralen Anteile zu zerlegen, und um es Solarzellen zuzuführen, die dem jeweiligen Spektralbereich angepasst sind. Die fokussierende Wirkung der dort gezeigten Anordnung wird jedoch durch eine Sammellinse hervorgerufen, die vor dem Prisma angeordnet ist. Dadurch ist es nicht möglich, das einfallende Licht so zu fokussieren, dass nur die Solarzellen und nicht der Zwischenraum zwischen diesen beleuchtet wird. Bei der bekannten Anordnung wird daher stets die gesamte Solarzellenfläche einschliesslich der Kontaktierungen und der Kontaktstege beleuchtet. Auch hier ist daher der Wirkungsgrad von vorneherein begrenzt.

Der Erfindung liegt daher die Aufgabe zu Grunde, eine Solarzellenanordnung der eingangs genannten Art so auszubilden, dass ein höherer Wirkungsgrad ohne zu grossen Aufwand erreichbar ist und dass vor allen Dingen eine relativ einfache Realisierung möglich ist.

Diese Aufgabe wird durch die Merkmale des Patentanspruches 1 gelöst. Durch diese Ausgestaltung kann das gesamte einfallende Licht so abgebildet werden, dass die Kontaktflächen ausgespart bleiben. Der Anteil der umgesetzten Solarenergie ist daher grösser. Durch die Verwendung der optisch wirksamen Gelatineschicht kann eine relativ kleine Bauform erreicht werden, bei der beispielsweise auch die Möglichkeit einer einfachen Verkapselung der ebenen optischen Elemente gegeben ist. Die Gelatineschicht weist auch ein relativ geringes optisches Rauschen auf. Die erfindungsgemässe Solarzellenordnung kann ein flaches, wenig raumbeanspruchendes Flächengebilde sein, das sich ohne grossen Aufwand dem Sonnenlicht aussetzen lässt.

Es ist zwar grundsätzlich bekannt gewesen (RCA-Review, Vol. 33, 1972, Nr. 1, Seiten 110–130), optische Elemente wie Vielfachlinsen durch Hologramme mit Hilfe von Gelatine-Schichten zu verwirklichen. Dass damit aber auch eine Kombination einer fokussierend und gleichzeitig dispersiv wirkenden Gelatineschicht erreichbar ist, die sich in besonders einfacher Weise mit einer Solarzellenanordnung vereinen lässt, wird nicht erwähnt. Das gilt auch für das Merkmal der fokussierenden Wirkung eines Gelatinehologramms, mit der eine Ausleuchtung nicht des gesamten Solarzellenfeldes, sondern nur der einzelnen Solarzellen erreicht werden kann. Vorteilhafte Ausgestaltungen des Gegenstandes der Erfindung sind in den Unteransprüchen aufgeführt. So kann die Gelatineschicht zwischen Glasschichten oder dergl. verkapselt sein, wobei eine Glasschicht bzw. eine Schicht aus transparentem Material zur Bildung des Abstandes zwischen Gelatineschicht und Solarzellen vorgesehen wird. Die neue Ausgestaltung weist auch den Vorteil auf, dass die Zwischenräume zwischen den Solarzellengruppen zur Anordnung der Kontakte und Stromsammelschienen ausgenutzt werden können, so dass das fertige Flächengebilde bereits anschlussfertig vorliegen kann.

Es ist bei einer abgewandelten Ausführung der Erfindung auch möglich, die Gelatineschicht und die Solarzellen nicht in parallelen Ebenen zueinander anzuordnen, sondern der Gelatineschicht und jeder Solarzelle einen Lichtleiter zuzuordnen, an dessen Ende die Solarzelle sitzt. Auch bei dieser Ausgestaltung übernimmt die optisch wirksame Gelatineschicht die Aufgabe, das einfallende Licht sowohl auf die verschiedenen Lichtleiter in Spektralbereichen zu dispergieren, als auch jeden Spektralbereich in dem Lichtleiter zu sammeln.

Auch diese Ausführung weist Vorteile auf, wobei hier die Solarzellen im wesentlichen in einer Reihe nebeneinander, oder untereinander, parallel zur Lichteinfallsfläche, aber mit ihrer Lichteinfallsfläche in einem Winkel, vorzugsweise senkrecht, zu dieser angeordnet werden.

Eine weitere vorteilhafte Ausgestaltungsmöglichkeit ergibt sich dadurch, dass die Gelatineschicht so ausgebildet ist, dass die Beleuchtungsintensität auf die einzelnen Solarzellenoberflächen verschieden aufgebracht wird, und zwar so, dass die Beleuchtungsintensität mit grösser werdendem Abstand zu den Kontakten geringer wird. Vorteilhaft kann natürlich auch bei dieser Ausführung die Gelatineschicht so ausgebildet werden, dass die vorgesehenen Kontaktgitter oder Sammelschienen von einer Beleuchtung ausgespart werden, so dass diese Bereiche kein Licht absorbieren und damit der Wirkungsgrad der Gesamtanordnung grösser wird. Die Merkmale des Anspruches 12 bringen den Vorteil mit sich, dass die Solarzellenanordnung dem Sonnenstand entsprechend nicht mechanisch nachgeführt werden muss.

Weitere Vorteile, insbesondere hinsichtlich der Kontaktanordnung ergeben sich aus den Unteransprüchen sowie aus der nachfolgenden Beschreibung von Ausführungsbeispielen der Erfindung, die in den Zeichnungen dargestellt sind. Es zeigen:

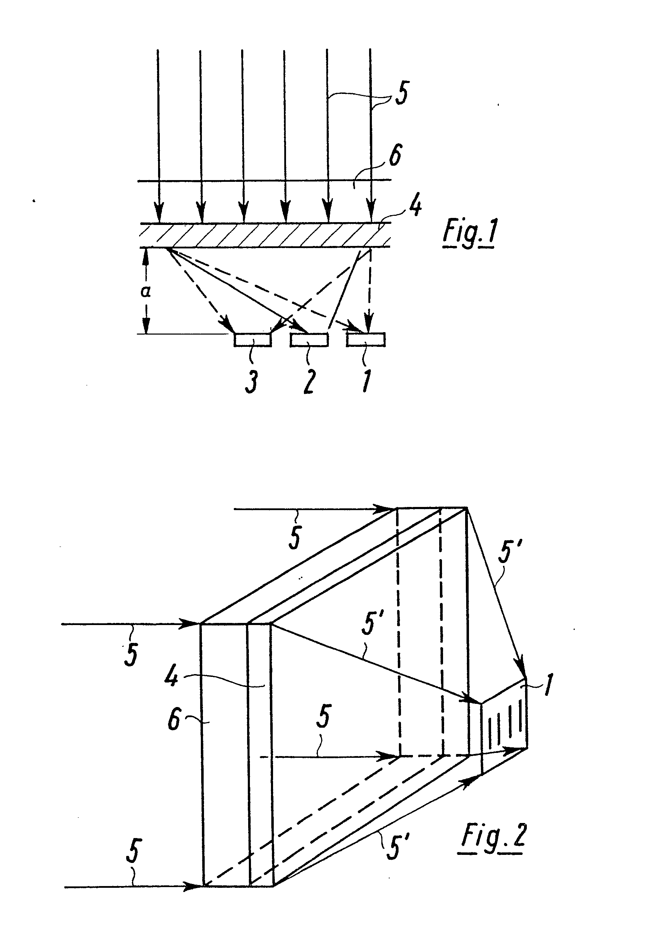

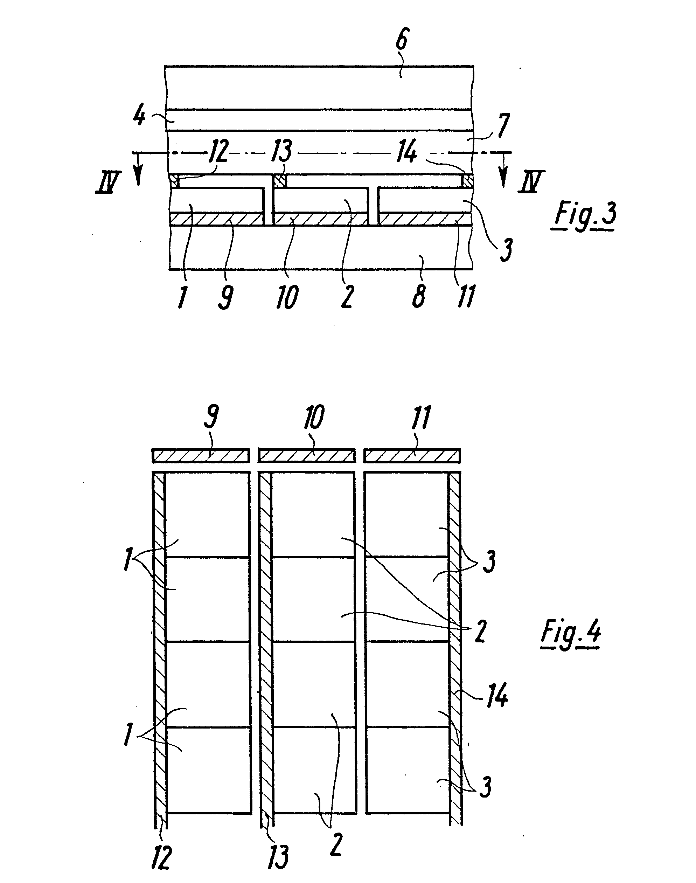

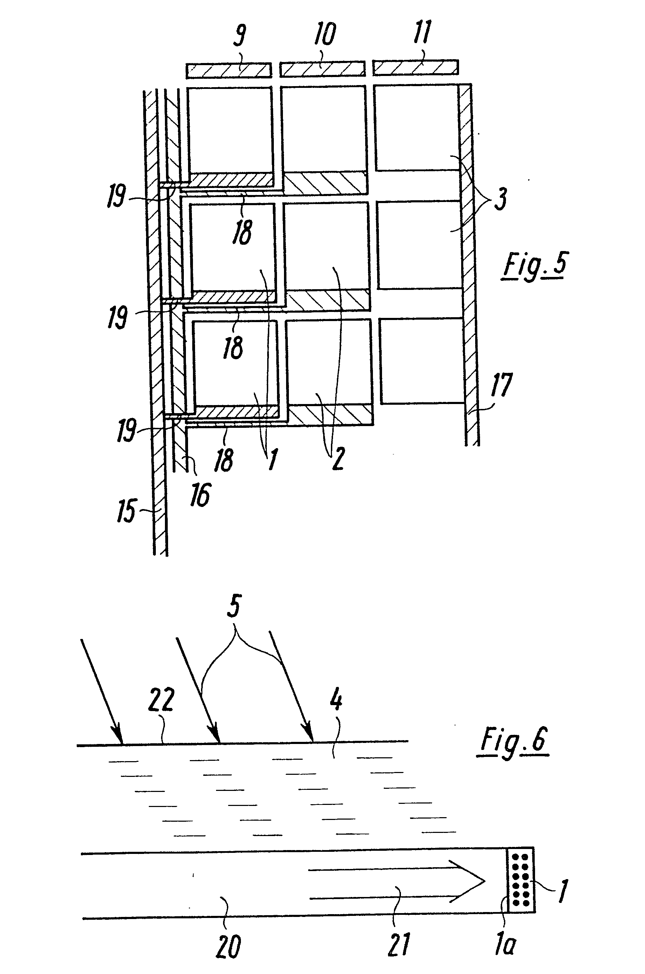

Figur 1 eine schematische Darstellung des grundsätzlichen Aufbaues der Solarzellenanordnung gemäss der Erfindung in einem Querschnitt, Figur 2 in perspektivischer Darstellung einen Ausschnitt aus einer erfindungsgemässen Anordnung, wobei nur eine Solarzelle mit dem ihr zugeordneten optischen System gezeigt ist, Figur 3 einen schematischen Teilschnitt durch ein erfindungsgemäss aufgebautes Flächengebilde, das platten- oder mattenförmig ausgebildet sein kann, Figur 4 den Schnitt durch die Figur 3 längs der Linie IV, Figur 5 einen Schnitt ähnlich Figur 4, jedoch bei einer anderen Ausführungsform des Kontaktsystems für die Solarzellen und Figur 6 schliesslich einen Schnitt ähnlich wie Figur 3, jedoch durch eine Solarzellenanordnung bei der die Solarzellen mit ihrer Lichteinfallfläche in einem Winkel zu der Lichteinfallfläche der optisch wirksamen Schicht angeordnet sind. Bei dieser Ausführung werden Lichtleiter eingesetzt.

Aus den Figuren 1 und 3 ist zu erkennen, dass erfindungsgemäss Solarzellen 1 und 2 bzw. 3 im Abstand a zu einer optisch wirksamen Schicht 4 angeordnet sind, auf deren Oberfläche die Strahlen 5 des einfallenden Lichtes, beispielsweise Sonnenlicht, auftreffen. Vor diese optisch wirksame Schicht 4 ist eine transparente Schicht, beispielsweise eine Glasschicht 6 oder eine andere transparente Schicht, gesetzt. Die optische Schicht 4 ist so ausgebildet, dass sie einmal, wie aus Fig. 2 hervorgeht, die Strahlen 5 des einfallenden Lichtes fokussiert, d. h. zu konvergierenden Strahlen 5' umsetzt, die dann auf die Oberfläche der Solarzelle 1 oder einer anderen Zelle fallen. Die optisch wirksame Schicht wird dabei aus einer in der Art eines Hologramms behandelten Gelatineschicht gebildet, welche einmal die optische Eigenschaft einer Sammellinse, d. h. eine fokussierende Eigenschaft aufweisen kann, wie das anhand von Fig. 2 gezeigt ist.

Da, wie aus Fig. 1 ersichtlich, für die neue Solarzellenanordnung mehrere Solarzellen 1, 2 und 3 usw. nebeneinander und im Ausführungsbeispiel in einer Ebene angeordnet sind, muss die optisch wirksame Schicht 4 ausserdem auch noch dispergierend wirken der Art, dass jeder der Solarzellen 1, 2 und 3 ein bestimmter Spektralbereich der einfallenden Strahlen 5 zugeordnet wird.

Diese dispergierenden Eigenschaften können ebenfalls in der Gelatineschicht verwirklicht werden und es wird dann erreicht, dass beispielsweise der Solarzelle 1 das blaue Bild der Sonne und der Solarzelle 3 das rote Bild der Sonne zugeordnet wird, wobei die dazwischenliegende Solarzelle 2 den anderen, zwischen Rot und Blau liegenden Spektralbereichen zugeordnet ist. Durch diese Anordnung wird daher erreicht, dass jede der gezeigten drei Solarzellen einen bestimmten Spektralbereich des einfallenden Lichtes 5 gesammelt auf ihrer Oberfläche erhält. Die Solarzellen 1, 2 bzw. 3 können daher auf diesen Spektralbereich abgestimmt werden, indem sie aus einem Material mit entsprechenden Bandabstand hergestellt werden. Auf diese Weise kann der Wirkungsgrad der einzelnen Solarzellen, wie eingangs angedeutet, verbessert werden.

Die gesamte Anordnung lässt sich, wie das anhand von Fig. 3 gezeigt ist, als ein Flächengebilde ausgestalten, wenn der Abstand a durch eine transparente Schicht 7, beispielsweise aus Glas oder durchsichtigem Kunststoff gebildet wird und wenn in dieses Substrat die Solarzellen 1, 2 und 3, einschliesslich der Gelatineschicht 4, eingesetzt sind. Auch den unteren Abschluss dieses Flächengebildes, das sich matten- oder plattenähnlich ausgestalten lässt, bildet eine durchsichtige Schicht 8, die aus dem gleichen Material wie die Schichten 6 und 7 bestehen kann.

Bei einer solchen Anordnung lässt sich auch das Problem der Kontaktierung der einzelnen Solarzellen 1, 2 und 3 verhältnismässig einfach lösen, wie das aus den Fig. 3 und 4 zu erkennen ist. Dort sind nämlich die Rückseitenkontakte 9, 10 und 11 jeweils nach einer Seite durchgezogen und lassen sich am Rand der Anordnung abgreifen, während die Frontkontakte als über jeweils eine Reihe von aus gleichem Material hergestellten Solarzellen 1 verlaufende Sammelschiene 12, 13, 14 ausgebildet sind die, wie aus Fig. 4 zu erkennen ist, an dem anderen Ende der Gesamtanordnung abzugreifen sind. Rückseiten- und Frontkontakte 9 bis 11 bzw. 12 bis 14 sind dabei jeweils, wie Fig. 3 erkennen lässt, mit in das Substrat aus den transparenten Schichten 6, 7 bzw. 8 eingelassen. Es entstehen so, wie Fig. 4 zeigt, jeweils durchgehende und zueinander parallele Reihen von Solarzellen 1, 2 bzw. 3 mit jeweils gleichen Absorptionseigenschaften, denen das einfallende Licht in der in Fig. 1 gezeigten Weise zugeleitet wird. Wird in diesem Fall, z. B. in der Gelatineschicht eine Zylinderlinse realisiert, so kann die Abbildung so gewählt werden, dass keine Lichtanteile auf die Kontaktflächen fallen.

Die Fig. 5 zeigt ein weiteres Beispiel für die Kontaktierung der Solarzellen 1, 2 bzw. 3, die auch in diesem Fall in zueinander parallelen Reihen angeordnet sind. Die Rückseitenkontakte 9, 10 und 11 sind dabei wieder in der gleichen Weise ausgebildet, wie das anhand von den Fig. 3 und 4 gezeigt ist, die Frontseitenkontakte 15, 16 und 17 dagegen sind jeweils an die Aussenseite des aus Fig. 5 zu erkennenden Streifens mit den Solarelementen 1, 2 und 3 verlegt. Dabei sind die Solarzellen 3 jeweils an den Rückseitenkontakt 17 angeschlossen, während die Solarzellen 2 unter Zwischenschaltung von Kontaktbrücken 18 an dem Rückseitenkontakt 16 anliegen und die Solarzellen 1 über die die Kontaktschiene 16 isolierend überbrückenden Kontaktstege 19 an den Rückseitenkontakt 15.

In der Fig. 6 ist eine Ausführungsform einer Solarzellenanordnung gezeigt, deren Grundaufbau bezüglich der Anordnung einer Gelatineschicht 4, welche fokussierend und dispersiv ist und die einfallenden Lichtstrahlen 5, ähnlich Fig. 1, in verschiedene Spektralbereiche auf seitlich nebeneinanderliegende Reihen aufteilt, ebenso ausgebildet ist wie die Anordnung der Fig. 1. Unterschiedlich ist lediglich, dass das Gelatinematerial direkt auf nebeneinanderliegenden Lichtleitern 20 angeordnet ist, welche in einer unter der Gelatineschicht liegenden Schicht ausgebildet sein können und die den einzelnen Spektralbereichen zugeordneten Anteile des einfallenden Lichtes von der Gelatineschicht 4 her aufnehmen und im Sinne des Pfeiles 21 zu den am Ende eines Lichtleiters 20 angeordneten, entsprechend ausgebildeten Solarzellen 1 bzw. 2 oder 3 führen. Es ist auch möglich, Lichtleiterflächen, beispielsweise in Form von Glasplatten, nicht nebeneinander, sondern untereinander anzuordnen, wobei jeder Lichtleiterfläche eine Gelatineschicht zugeordnet wird, die in diesem Fall das entsprechende Spektrum des Lichtes ausfiltert und in die Lichtleiterfläche einkoppelt. Die anderen Spektralbereiche durchdringen die einzelnen Schichten nahezu ungedämpft. In beiden Fällen sind die Solarzellen 1 und die nicht gezeigten Zellen 2, 3 mit ihrer Lichteinfallfläche 1a nicht, so wie in den Fig. 1 bis 5 parallel zu der Einfallfläche 22 der Gelatineschicht 4 angeordnet, sondern sie stehen mit dieser Fläche 1a in einem Winkel, vorzugsweise senkrecht, dazu. Auch bei diesen Ausgestaltungen lassen sich die Gelatineschicht 4 und die Lichtleiter bzw. Lichtleiterflächen 20 in einem transparenten Substrat unterbringen, so dass auch hier platten- oder folienähnliche Streifen für die Solarzellenanordnung gewonnen werden können, die anschliessend eine sehr leichte Verlegung an den gewünschten, der Sonneneinstrahlung ausgesetzten Stellen, ermöglichen.

**Patentansprüche**

1. Solarzellenanordnung mit mindestens zwei Solarzellen unterschiedlicher Absorptionsfähigkeit und einem optischen System, das sowohl fokussierend als auch dispersiv wirkt und das das einfallende Licht auf die Oberflächen der Solarzellen in der Weise abbildet, dass jeder Solarzelle das ihrer jeweiligen Absorptionsfähigkeit entsprechende spektrale Licht zugeleitet wird, dadurch gekennzeichnet, dass das optische System eine zwischen einer Lichteinfallsfläche und den Solarzellen (1, 2, 3) angeordnete optisch wirksame Gelatine-Schicht (4) ist, die in der Art eines Hologramms behandelt ist, so dass sie sowohl fokussierend als auch dispersiv wirkt.

2. Solarzellenanordnung nach Anspruch 1, dadurch gekennzeichnet, dass die optisch wirksame Gelatine-Schicht (4) mit einem Abstand (a) zu den Solarzellen angeordnet ist.

3. Solarzellenanordnung nach Anspruch 1 oder 2, dadurch gekennzeichnet, dass die Solarzellen (1, 2, 3) parallel geschaltet sind.

4. Solarzellenanordnung nach einem oder mehreren der Ansprüche 1 bis 3, dadurch gekennzeichnet, dass die Solarzellen (1, 2, 3) nebeneinander angeordnet sind.

5. Solarzellenanordnung nach Anspruch 4, dadurch gekennzeichnet, dass die Solarzellen (1, 2, 3) in einer Ebene angeordnet sind und dass die optisch wirksame Gelatine-Schicht (4) ebenfalls eben ausgebildet ist.

6. Solarzellenanordnung nach den Ansprüche 4 und 5, dadurch gekennzeichnet, dass die Gelatine-Schicht (4) geschützt unterhalb einer transparenten Abdeckschicht (6) angeordnet ist.

7. Solarzellenanordnung nach den Ansprüchen 2 bis 6, dadurch gekennzeichnet, dass zur Bildung des Abstandes (a) zwischen der Gelatine-Schicht (4) und den Solarzellen (1, 2, 3) eine Schicht (7) aus transparentem Material vorgesehen ist.

8. Solarzellenanordnung nach einem der Ansprüche 4 bis 7, dadurch gekennzeichnet, dass die Zwischenräume zwischen den Solarzellengruppen (1, 2, 3) zur Anordnung der Kontakte (9, 10, 11) und Stromsammelschienen (12, 13, 14) ausgenutzt sind.

9. Solarzellenanordnung nach Anspruch 1, dadurch gekennzeichnet, dass das optische System weiterhin einen der Gelatine-Schicht (4) und jeder Solarzelle (1) zugeordneten Lichtleiter (20) umfasst, an dessen Ende die Solarzelle sitzt (Fig. 6).

10. Solarzellenanordnung nach Anspruch 9, dadurch gekennzeichnet, dass die Solarzellen (1) in einer Reihe und mit ihrer Lichteinfallsfläche (1a) unter einem Winkel zur Lichteinfallsfläche (22) der Gelatine-Schicht (4) angeordnet sind.

11. Solarzellenanordnung nach Anspruch 10, dadurch gekennzeichnet, dass der Winkel 90° beträgt.

12. Solarzellenanordnung nach einem der Ansprüche 1 bis 10, dadurch gekennzeichnet, dass die Gelatine-Schicht (4) so ausgebildet ist, dass die Beleuchtungsintensität auf den einzelnen Solarzellenoberflächen verschieden aufgebracht wird, und zwar so, dass die Beleuchtungsintensität mit grösser werdendem Abstand zu den Kontakten geringer wird.

**Claims**

1. Solar cell arrangement having at least two solar cells of different absorption capacity and an optical system exercising both a focusing and also a dispersive action and which displays the incident light on the surfaces of the solar cells in such a way that the spectral light corresponding to the relevant absorption capacity of each solar cell is conveyed to the latter, characterised in that the optical system is an optically active gelatin layer (4) disposed between a light incidence area and the solar cells (1, 2, 3) and which is treated in the manner of a hologram so that it has both a focusing and also a dispersive action.

2. Solar cell arrangement according to Claim 1, characterised in that the optically acting gelatin layer (4) is disposed at a distance (a) from the solar cells.

3. Solar cell arrangement according to Claim 1 or 2, characterised in that the solar cells (1, 2, 3) are connected in parallel.

4. Solar cell arrangement according to one or more of Claims 1 to 3, characterised in that the solar cells (1, 2, 3) are disposed beside one another.

5. Solar cell arrangement according to Claim 4, characterised in that the solar cells (1, 2, 3) are disposed in one plane and in that the optically active gelatin layer (4) is likewise of plane construction.

6. Solar cell arrangement according to Claims 4 and 5, characterised in that the gelatin layer (4) is disposed in protected fashion under a transparent covering layer (6).

7. Solar cell arrangement according to Claims 2 to 6, characterised in that a layer (7) of transparent material is provided in order to constitute the distance (a) between the gelatin layer (4) and the solar cells (1, 2, 3).

8. Solar cell arrangement according to one of Claims 4 to 7, characterised in that the intermediate spaces between the solar cell groups (1, 2, 3) are utilised for locating the contacts (9, 10, 11) and the current collecting bars (12, 13, 14).

9. Solar cell arrangement according to Claim 1, characterised in that the optical system furthermore comprises, associated with the gelatin layer (4) and each solar cell (1) a light conductor (20) at the end of which the solar cell is mounted (Fig. 6).

10. Solar cell arrangement according to Claim 9, characterised in that the solar cells (1) are located in one row, their light incidence area (1a) being located at an angle to the light incidence area (22) of the gelatin layer (4).

11. Solar cell arrangement according to Claim 10, characterised in that the angle is 90°.

12. Solar cell arrangement according to one of Claims 1 to 10, characterised in that the gelatin layer (4) is so constructed that the intensity of lighting is variously applied to the individual solar cell surface, in fact in such a way that the lighting intensity grows less with increasing distance from the contacts.

**Revendications**

1. Panneau de cellules solaires comportant au moins deux cellules solaires de capacité d'absorption différente ainsi qu'un système optique qui agit aussi bien par focalisation que par dispersion et qui donne, de la lumière incidente, sur les surfaces des cellules solaires, une image telle qu'à chaque cellule solaire est amenée la lumière spectrale correspondant à sa capacité d'absorption respective, caractérisé en ce que le système optique est une couche de gélatine (4), optiquement active, disposée entre une surface d'incidence de la lumière et les cellules solaires (1, 2, 3) et traitée à la façon d'un hologramme, de sorte qu'elle agit aussi bien par focalisation que par dispersion.

2. Panneau de cellules solaires selon la revendication 1, caractérisé en ce que la couche de gélatine (4) optiquement active est disposée à une certaine distance (a) des cellules solaires.

3. Panneau de cellules solaires selon la revendication 1 ou la revendication 2, caractérisé en ce que les cellules solaires (1, 2, 3) sont couplées en parallèle.

4. Panneau de cellules solaires selon une ou plusieurs des revendications 1 à 3, caractérisé en ce que les cellules solaires (1, 2, 3) sont disposées l'une à côté de l'autre.

5. Panneau de cellules solaires selon la revendication 4, caractérisé en ce que les cellules solaires (1, 2, 3) sont disposées dans un plan et en ce que la couche de gélatine (4) optiquement active a également une forme plane.

6. Panneau de cellules solaires selon les revendications 4 et 5, caractérisé en ce que la couche de gélatine (4) est disposée protégée en dessous d'une couche de couverture (6) transparente.

7. Panneau de cellules solaires selon les revendications 2 à 6, caractérisé en ce que pour donner la distance (a) entre la couche de gélatine (4) et les cellules solaires (1, 2, 3) est prévue une couche (7) de matériau transparent.

8. Panneau de cellules solaires selon l'une des revendications 4 à 7, caractérisé en ce que les volumes intermédiaires situés entre les groupes de cellules solaires (1, 2, 3) sont utilisés pour disposer les contacts (9, 10, 11) et les barres collectrices du courant (12, 13, 14).

9. Panneau de cellules solaires selon la revendication 1, caractérisé en ce que le système optique comporte en outre un conducteur optique (20) correspondant à la couche de gélatine (4) et à chaque cellule solaire (1) et à l'extrémité duquel se trouve la cellule solaire (figure 6).

10. Panneau de cellules solaires selon la revendication 9, caractérisé en ce que les cellules solaires (1) sont disposées sur une rangée, avec leur surface d'incidence de la lumière (1a) faisant un certain angle avec la surface d'incidence de la lumière (22) de la couche de gélatine (4).

11. Panneau de cellules solaires selon la revendication 10, caractérisé en ce que l'angle vaut 90°.

12. Panneau de cellules solaires selon l'une des revendications 1 à 10, caractérisé en ce que la couche de gélatine (4) est conçue de façon que l'intensité d'éclairement s'applique de façon différente sur les différentes surfaces des cellules solaires et, de façon plus précise, de façon que l'intensité d'éclairement diminue si la distance aux contacts croît.

Fig. 1

Fig. 2

Fig.3

Fig.4

_Fig. 5_

_Fig. 6_